# EUROPEAN PATENT APPLICATION

(11) **EP 2 624 268 A1**
(43) Date of publication of application: **07.08.2013**
(21) Application number: 11748868.4
(22) Date of filing: 22.03.2011
(51) Int. Cl.: H01G 9/00

(54) **SURFACE MOUNT SOCKET FOR ELECTROLYTIC CAPACITOR AND SURFACE MOUNT METHOD FOR ELECTROLYTIC CAPACITOR**

(30) Priority: 30.09.2010 JP 2010220862
(71) Applicant: Omron Corporation, Kyoto-shi, Kyoto 600-8530 (JP)
(72) Inventor: SHIMIZU, Ryoji, KYOTO 600-8530 (JP); SATO, Makoto, KYOTO 600-8530 (JP)
(74) Representative: Kilian Kilian & Partner
(86) International application number: PCT/JP2011/056715
(87) International publication number: WO 2012/042937

(57) **Abstract**

The invention allows a high capacitance electrolytic capacitor to be surface-mounted and replaced by a new one and thereby increases an effectiveness of repetitive use of an electric circuit used therewith. For this purpose, a socket 11 for a surface-mounting of an electrolytic capacitor 61, the capacitor having a housing 62 and leads 63, 64 extending from a bottom surface of the housing 62, comprises a support 12 for receiving the bottom surface of the capacitor. The support 12 has a holder 13 for releasably holding a portion of the housing 62 of the capacitor 61 adjacent to the leads 63, 64; connecting terminals 31 for electrically connecting the leads 63, 64 to a circuit substrate 51; a recess 14 defined in a top surface of the support 12 for accommodating a deformation of a seal rubber 65 provided at a bottom portion of the housing 62 of the capacitor 61; and grooves 15 defined in a bottom surface of the support 12 for drawing the connecting terminals 31.

## Description

### TECHNICAL FIELD

The present invention relates to a surface mounting socket for electrolytic capacitors. More specifically, the present invention relates to a surface mounting socket for electrolytic capacitors which allows surface mountings of high capacitance electrolytic capacitors and also relates to a surface mounting socket for electrolytic capacitors which allows electric circuits supporting electrolytic capacitors to be reused.

### BACKGROUND OF THE INVENTION

Conventionally, there have been used two ways for mounting electric components onto a circuit substrate, i.e., a through-hole mounting and a surface mounting. According to the through-hole mounting, the electric component is soldered and fixed to the circuit substrate with its leads inserted in the associated through-holes formed in the circuit substrate. According to the surface mounting, the electric component is mounted on the circuit substrate by applying a solder paste on the circuit substrate, mounting electric components on the applied paste, fusing the solder paste and cooling the fused solder paste to fix the electric component to the circuit substrate. Among these mounting methods, the surface mounting is likely to be more employed than the through-hole mounting in response to the requirements of multifunctionality, compactness and high-density mounting of electronic devices.

Practically, however, the through-hole and surface mountings have both been employed because some circuit components such as high capacitance electrolytic capacitor are difficult to be mounted by means of the reflow process which is advantageously used with the surface mounting.

Specifically, the solder paste supporting the electric component can not be well melted because large aluminum housings of the high capacitance electrolytic capacitors disadvantageously absorb heat in the reflow oven before it is transmitted to the solder paste. Indeed, by increasing a temperature in the reflow oven, the solder paste is more likely to be melted, which in turn deteriorates the heat-sensitive, electrolytic capacitors and other electronic components.

JP 11-26327 A discloses a seat plate for use in surface mountings of the electrolytic capacitors. The seat plate allows the electrolytic capacitor to be surface-mounted directly on the circuit substrate but it has the same problem and therefore fails to overcome the difficulties in the mountings.

Therefore, the lead components are selected for the electric components such as high capacitance electrolytic capacitors, which results in a current situation in which the lead and surface mounting components are used in mixture and therefore the through-hole and surface mountings are both used.

This in turn requires two different steps of surface mounting and through-hole mounting, which is more costly than using either one of two steps.

The electrolytic capacitor is primarily used together with other electric components in a smoothing circuit of power supply.

The electrolytic capacitor has relatively shorter life than other electric components. Typically, among others low capacitance electrolytic capacitors have shorter lives than high capacitance electrolytic capacitors. Then, a life of the electric circuit on which the low capacitance capacitor is mounted is determined by the life of the low capacitance capacitor.

Further, although in order to reuse the electric circuit it is necessary for the deteriorated electrolytic capacitor to be replaced by a new one, it is not easy to remove the capacitors mounted on the substrate by the through-hole mountings and the surface mountings.

Although not designed for the surface mountings, JUM 3-68386 A discloses another socket for electrolytic capacitors. The socket comprises a plate-like base from which electrically conductive legs are extended downwardly and a cover which is engaged with the base to fix the electrolytic capacitor on the base. Each of the conductive legs is designed to have an insert hole into which the associated lead of the capacitor is fitted and a tip portion which extends coaxially with the leg. The tip portions of the legs are solder to the associated portions of the circuit substrate, so that the base is floatingly fixed to the substrate.

According to the arrangement, the electrolytic capacitor can be fixed to and unfixed from the substrate simply by inserting and drawing the capacitor, which allows the deteriorated capacitor to be replaced by a new one and the electric circuit to be reused.

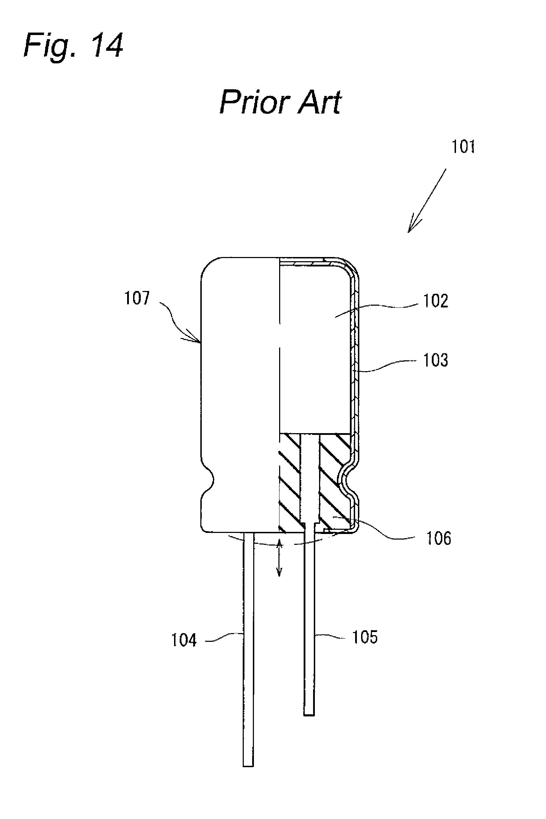

However, as shown in Fig. 14, the electrolytic capacitor 101 has a housing 103 for accommodating several components and electrolyte. Leads 104 and 105 are extended out through the lower end opening of the housing. The opening is closed by a rubber seal 106. Accordingly, an internal pressure within the housing may increase in response to atmospheric temperature, voltage and ripple current applied thereto or the like. The pressure increase causes an expansion of the rubber seal 106 as indicated in Fig. 15 by an imaginary line. The expanded rubber seal, since it is in contact at its bottom surface with the socket base, forces its housing 107 away from the substrate, which loses a retaining force of the capacitor 101.

The losing of the retaining force results in a reduction of resistance to vibrations, which may in turn degrade the circuit performance including an unwanted dropping of the electrolytic capacitor from the substrate to result in a cancellation of the advantages such as repetitive usage of the circuit.

Accordingly, the present invention is to permit the high capacitance electrolytic capacitor to be surface-mounted and also replaced by a new one and, thereby, to maintain the effectiveness of the repetitive usage of the circuit.

### SUMMARY OF THE INVENTION

Therefore, a socket for a surface-mounting of an electrolytic capacitor, the capacitor having a housing and leads extending from a bottom surface of the housing, comprises a support for receiving the bottom surface of the capacitor, the support having a holder for releasably holding a portion of the housing of the capacitor adjacent to the leads, connecting terminals for electrically connecting the leads to a circuit substrate, a recess defined in a top surface of the support for accommodating a deformation of a seal rubber provided at a bottom portion of the housing of the capacitor, and drawing passages defined in a bottom surface of the support for drawing the connecting terminals.

According to the arrangement, the electrolytic capacitor is releasably held by the holder. Also, the holder stabilizes the housing of the electrolytic capacitor and maintains a force for holding the electrolytic capacitor while allowing the deformation of the seal rubber. Further, the connecting terminals on the support allow the surface-mounting of the socket to the circuit substrate.

Preferably, the support has a groove extending from an outer peripheral surface of the support to the recess. According to this arrangement, air moves through the connecting groove in response to expansions and contractions of the seal rubber, which ensures the expansions and contractions without any restriction and thereby maintains a holding force of the holder in a stable manner.

Preferably, the groove is positioned on a plane crossing the connecting terminals to which the leads are connected. This causes that the connecting groove passes through positions where the leads of the electrolytic capacitor are inserted, so that the groove works as a guide mark when holding the electrolytic capacitor by the holder.

Preferably, the holder has an engaging means for engaging an associated constriction defined at the housing of the capacitor. This allows that the engaging means holds the electrolytic capacitor in a stable manner to prevent the electrolytic capacitor from dropping due to vibrations.

Preferably, the engaging means is made of an engaging spring which is extended downwardly from an upper portion of the holder and is elastically deformable in an inside-outside direction. This allows that the engaging spring is designed to be longer and therefore the capacitor is held firmly while reducing stress applied to the capacitor even for the commercially available products having differences in diameter of the housings thereof and/or in size and shape of the constrictions.

Preferably, the drawing passages are made of grooves designed to accommodate the respective connecting terminals. This allows that at the surface-mounting each of the connecting terminals is oriented in any one of plural directions, which expands the possibility of circuit design to obtain a compact and simple circuit pattern as necessary.

Preferably, each of the connecting terminals has a bottomed-hole into which the lead is inserted and a spring provided at an inner surface of the bottomed-hole for elastically holding the inserted lead. This allows that the spring makes an elastic contact with the lead to establish a reliable electric connection, which reduces a stress to be applied to the lead being inserted. The bottomed-hole prevents a fluid leaked from the capacitor from reaching other portions such as circuit substrate.

Another approach for solving the problem is a method for a surface-mounting of an electrolytic capacitor, comprising the steps of mounting the socket on a circuit substrate by a reflow process; and retaining the electrolytic capacitor by the holder.

This arrangement allows that only the surface-mounting socket is soldered and fixed to the circuit substrate and then the electrolytic capacitor is held by the socket, which permits the surface-mounting to be performed in a relatively low-temperature reflow oven. Also, the electrolytic capacitor is not exposed to a high-temperature, which in turn means that the capacitor is protected from excessive heat.

As described above, the invention allows high capacitance electrolytic capacitors to be surface-mounted. This in turn allows that electric components are mounted by means of the surface mounting only.

Further, since the electrolytic capacitor can be removed and therefore the circuit can be reused easily. In addition, the recess of the support allows the deformations of the seal rubber while maintaining a stable holding of the capacitor by the holder. This prevents the capacitor from dropping and allows the reuse of the capacitor while maintaining a reliable operation of the circuit.

### BRIEF DESCRIPTION OF THE DRAWINGS

Fig. 1 is an elevational view showing a mounted socket for a surface mounting of electrolytic capacitor;

Fig. 2 is a perspective view of the socket;

Fig. 3 is an elevational view of the socket;

Fig. 4A is a top plan view of the socket;

Fig. 4B is a bottom plan view of the socket;

Fig. 5A is a cross sectional view taken along lines A-A in Fig. 4A;

Fig. 5B is a cross sectional view taken along lines B-B in Fig. 4A;

Fig. 6A is a cross sectional view showing a relationship between the socket and the electrolytic capacitor;

Fig. 6B is a cross sectional view showing a relationship between the socket and the electrolytic capacitor;

Fig. 7 is a side elevational view showing how the electrolytic capacitor is inserted in the socket for electrolytic capacitors;

Fig. 8 is a view showing an operational state of the socket;

Fig. 9A is a view showing a process for mounting the socket;

Fig. 9B is a view showing a process for mounting the socket;

Fig. 9C is a view showing a process for mounting the socket;

Fig. 10A is a view showing a process for mounting the electrolytic capacitor;

Fig. 10B is a view showing a process for mounting the electrolytic capacitor;

Fig. 11 is a view showing an operational state of the socket;

Fig. 12 is a bottom view showing a surface-mounting socket for electrolytic capacitors according to another embodiment;

Fig. 13 is a perspective view showing a surface-mounting socket for electrolytic capacitors according to another embodiment; and

Fig. 14 is a partially cutout cross sectional view showing an internal structure of the capacitor.

### DETAILED DESCRIPTION OF THE PREFERRED EMBODIMENTS

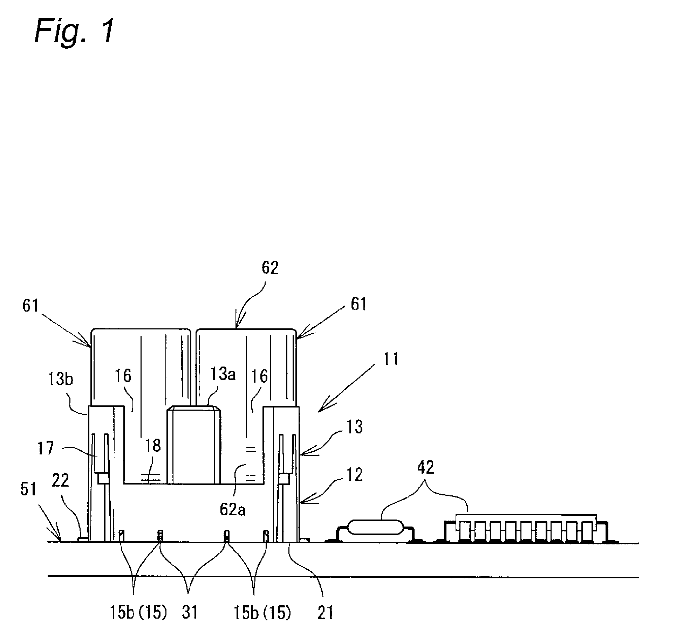

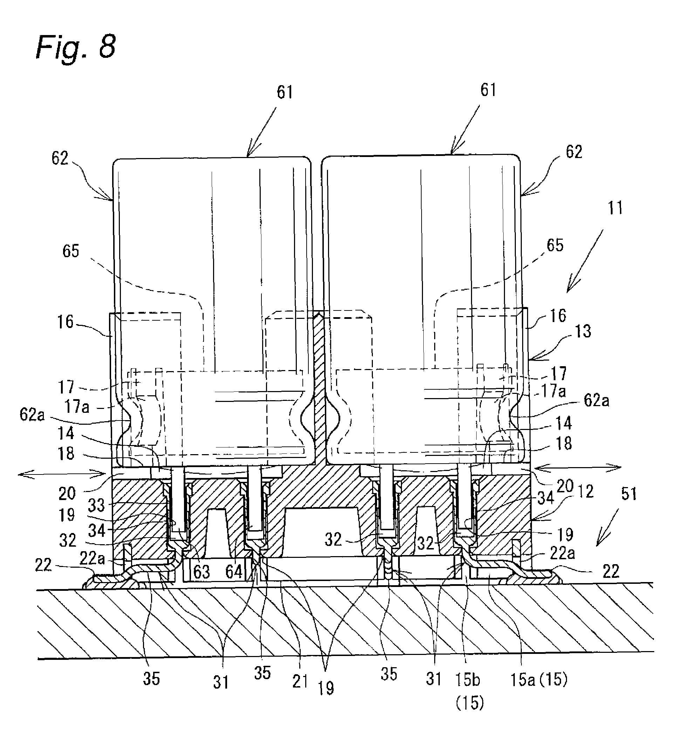

Referring to the accompanying drawings, an embodiment of the invention will be described. Fig. 1 shows a cross sectional view showing an operational state of a socket 11 for electrolytic capacitors. As shown in the drawing, the socket 11 is designed so as to allow high capacitance electrolytic capacitors 61 to be surface-mounted on a circuit substrate. In the embodiment, the electrolytic capacitor 61 is a general purpose capacitor which comprises a housing 62 and two leads 63 and 64 as positive and negative terminals positioned at a bottom portion of the housing 62 (see Fig. 8).

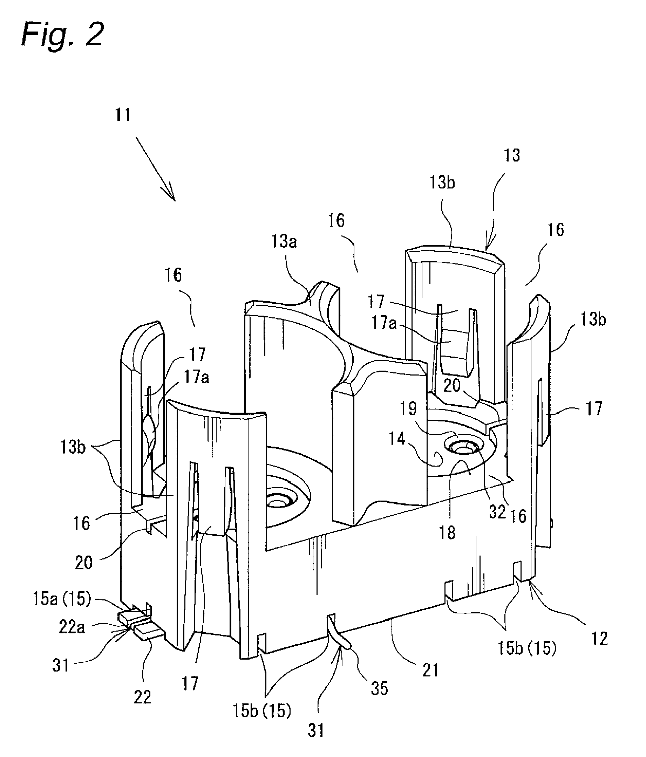

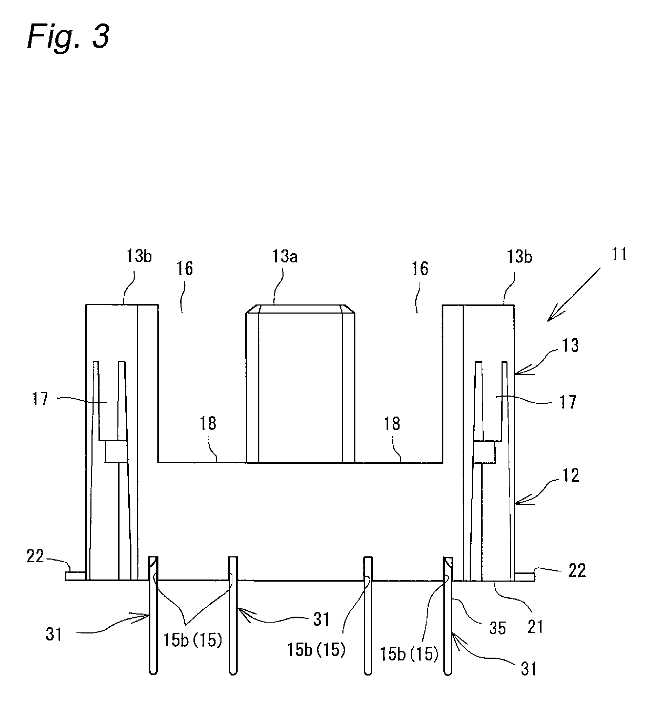

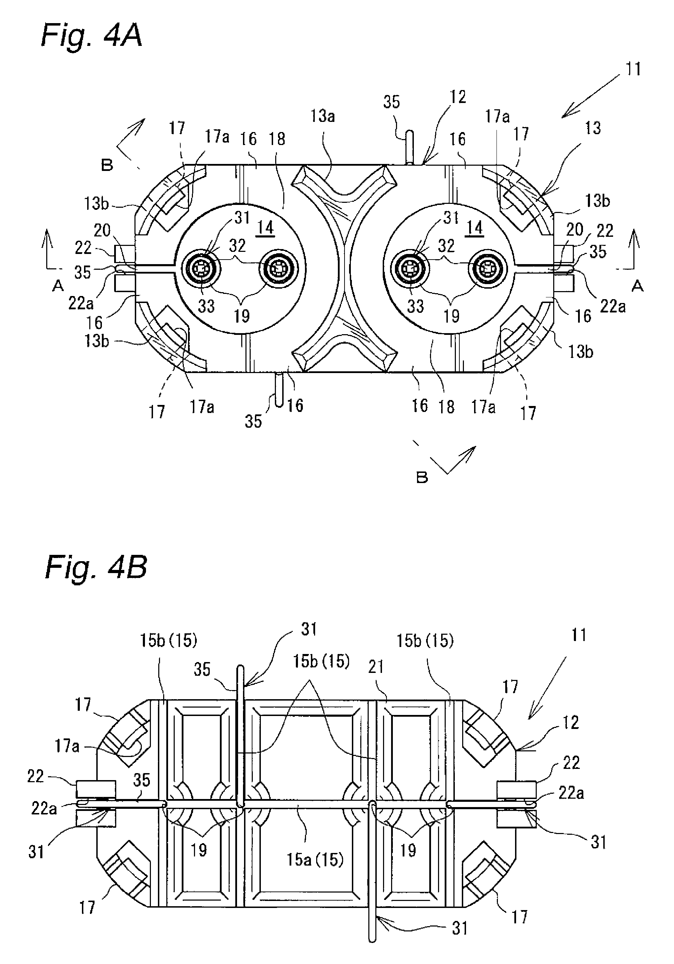

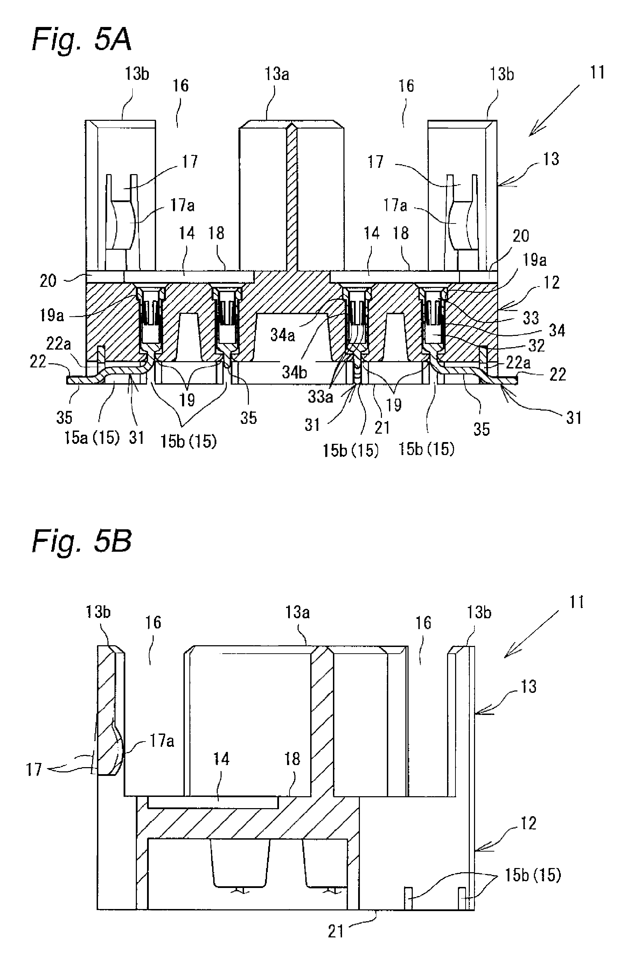

Discussions will be made to a general construction of the socket. Fig. 2 is a perspective view of the socket from seen above. Fig. 3 is a plan view of the socket. Figs. 4A and 4B are top and bottom plan views of the socket 11 viewed from its above and below, respectively. Figs. 5A and 5B are cross sectional views taken along lines A-A and B-B in Fig. 4A, respectively. As shown in the drawings, the socket 11 comprises a support 12 for supporting the bottom surface of the housing 62 of the capacitor 61. The support 12 comprises a holder 13 formed therewith for releasably holding portions of housings 62 of the electrolytic capacitors 61, adjacent to the leads 63, 64 and a plurality of connecting terminals 31 for the electrical connections of the leads 63 and 64 extending from the housing 62 of the capacitor 61 to the associated portions of the circuit substrate 51. The support 12 also comprises a plurality of recesses 14 formed at the top portions thereof for accommodating expansions of the rubber seals 65 sealingly fitted in respective bottom openings of the housings 62 of the electrolytic capacitors 61 (see Fig. 8). The support 12 further comprises drawing passages or grooves 15 for drawing the connecting terminals 31.

Specifically, the support 12 and the holder 13 are made of synthetic resin and integrally formed with each other. The support 12 is designed to have substantially a rectangular configuration when viewed from above, which allows that two electrolytic capacitors 61 are arranged side by side on the support 12 with their leads 63 and 64 oriented downwardly. The holder 13 is provided to extend upwardly from peripheral portions of the top surface of the support 12.

Although the holder 13 may be a hollow cylinder capable of surrounding substantially an entire portion of the housing 62 of the electrolytic capacitor 61, as shown in Figs. 2 and 4 it is designed to have a plurality of cutouts 16 in this embodiment. For example, the holder 13 has an inside holder portion 13a provided at an intermediate portion of the support 12 with respect to its longitudinal direction and two pairs of outside holder portions 13b provided at the four corners of the support 12. Also, the inside and outside holder portions 13a and 13b are so arranged to form the cutouts 16 between the inside and outside holder portions 13a and 13b and between the outside holding portions 13b, respectively, which allows that peripheral three surface portions of each electrolytic capacitor 61 held on the support 12 are exposed between the neighboring holding portions.

Each holder 13 is designed to have a certain height needed for holding the housing 62 of the electrolytic capacitor 61 with a suitable holding force.

Each of the two paired outside holder portions 13b has an engaging means to make a secure engagement with an associated recess or constriction 62a formed in the housing 62 of the electrolytic capacitor 61, which allows that the holder securely holds the housing 62 of the electrolytic capacitor 61.

Although the engaging means may be made of elongated projections formed integrally on an internal peripheral surface of the holder 13, as shown in Fig. 5B it is constituted by engaging springs 17 capable of moving elastically in radial directions in the embodiment. The engaging springs 17 are formed at intermediate portions of outside holder portions 13b with respect to the widthwise directions thereof to extend downwardly from upper portions thereof. The distal ends of the engaging springs 17 have projections 17a integrally formed therewith and projecting inwardly therefrom. The projections 17a are so positioned and sized as to engage with the associated constrictions 62a of the housing 62 of the electrolytic capacitor 61.

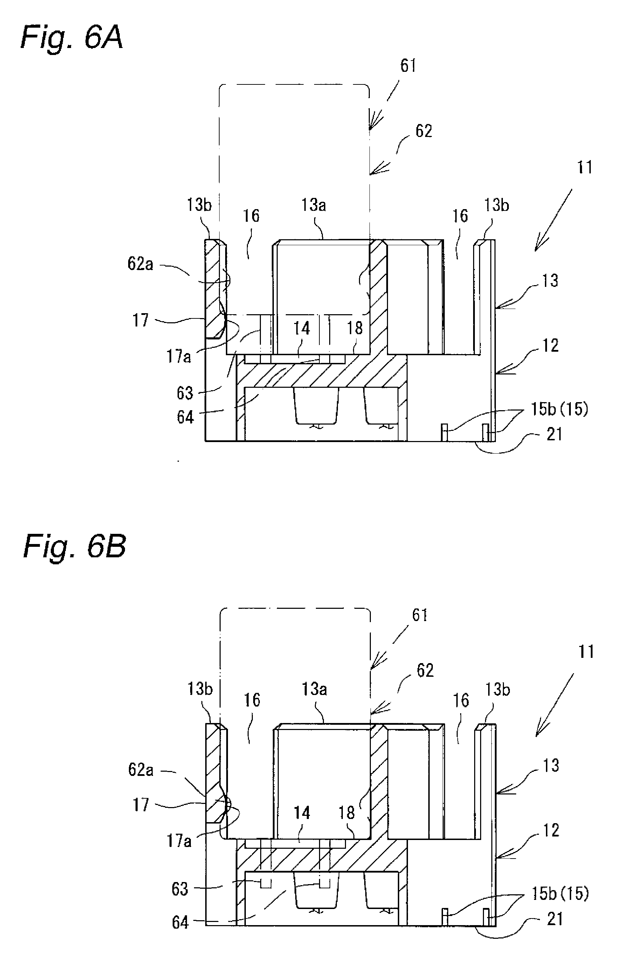

A height and shape of the projections and lengths of the leads 63 and 64 of the electrolytic capacitor 61 are so determined that the projections 17a of the engaging springs 17 do not engage with the associated constrictions 62a when the electrolytic capacitor 61 is not retained firmly as shown in Fig. 6A, but the projections 17a of the engaging springs 17 come to engage with the associated constrictions 62a with click actions when the electrolytic capacitor 61 has been securely retained as shown in Fig. 6B, which ensures a secure mounting of the electrolytic capacitor 61.

The peripheral portions of the support 12 inside the lower ends of the holder 13 so constructed have a flat surface portion 18 for supporting a lower end of the housing 62 of the electrolytic capacitor 61 (see Figs. 1 and 6A, 6B).

The recess 14 is formed inside the supporting surface portion 18 to oppose the lowermost end rubber seal 65 provided at the bottom opening of the housing 62 of the electrolytic capacitor 61 so that it can accommodate the deformation of the seal rubber 65. The recess 14 is circular in shape when viewed from above and has a suitable depth which is determined by an amount of expansion of the seal rubber 65.

An inside bottom surface of the recess 14 has two through holes 19 extending therethrough for receiving the connecting terminals 31 therein. As shown in Fig. 5A, each through hole 19 is so designed that it has an upper larger diameter portion, a lower smaller diameter portion and a step 19a defined therebetween, which allows that the connecting terminal 31 is press fitted and securely held in the through hole 19. As shown in Fig. 4A, each pair of through holes 19 are arranged in parallel to each other and spaced away from each other in the longitudinal direction of the support 12.

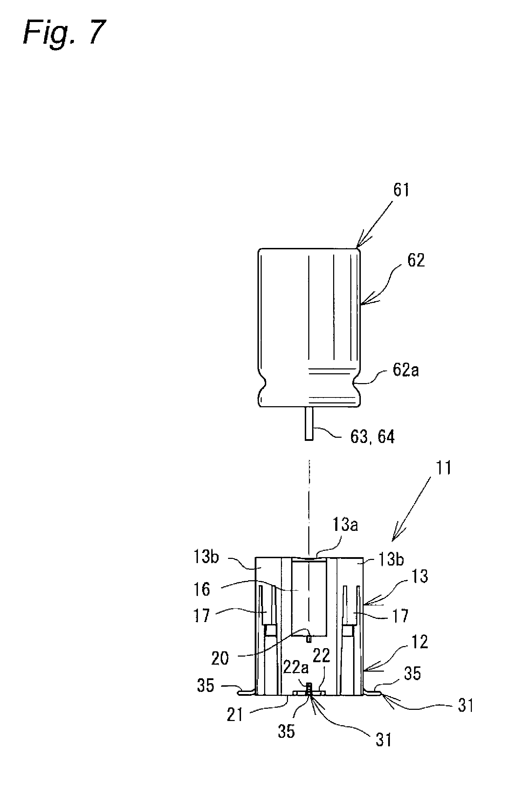

As shown in Figs. 4A and 5A, the support 12 comprises a connecting groove 20 defined therein to extend from the outer peripheral surface of the support 12 to the interior of the recess 14. The connecting groove 20 is configured to have a suitable width and depth and extend linearly along a plane connecting centers of the paired through holes 19. For example, as shown in Figs. 2 and 4, the groove 20 is formed in the support surface portion 18 across the cutout 16 between the neighboring outside holder portions 13b. This arrangement ensures that, as shown in Fig. 7, the leads 63 and 64 of the electrolytic capacitor 61 are aligned with the connecting groove 20 by mounting the electrolytic capacitor 61 in the holder 13.

If the through holes 19 are positioned on a different line, the connecting groove may be extended in that line accordingly.

Further, as shown in Fig. 8, the bottom surface of the support 12 defines a contact surface 21 to be brought into contact with the circuit substrate 51. The contact surface 21 has a pair of fixing clamps 22 positioned on opposite sides with respect to the longitudinal direction of the support 12 and projecting downwardly. As shown in Figs. 1 and 2, the fixing clamps 22, which are to be soldered to the circuit substrate 51, are provided to project from the longitudinal opposite ends of the support 12.

The grooves 15 are so formed that the connecting terminals 31 are extended out with lower ends thereof positioned at the same level as the lower ends of the fixing clamps 22. The grooves 15 are provided for respective connecting terminals 31 or through-holes 19. Specifically, as shown in Fig. 4B, one groove 15a is extended in a longitudinal direction of the support 12 and four grooves 15b are extended in a transverse direction of the support 12. Also, for the groove 15a extending in the longitudinal direction, cutouts 22a are formed in respective intermediate portions of the clamps 22 with respect to the transverse direction to communicate with the longitudinal groove 15a.

Each of the connecting terminals 31, which is made of electrically conductive metal material and has a pin-like configuration, comprises an insert hole 32 in the form of bottomed hole into which the lead is inserted as shown in Fig. 5A. The inner peripheral surface of the hole 32 has springs 33 for elastically holding the lead inserted in the hole 32.

Specifically, the connecting terminal 31 has an upper larger diameter portion 34 and a lower smaller diameter portion 35, both received within the through hole 19. The larger diameter portion 34, which defines the insert hole 32 therein, has a flange 34a which engages with the step 19a of the through-hole 19 and a peg 34b which engages in the smaller diameter portion of the through-hole 19 positioned below the step 19a. Also, the larger diameter portion 34 has substantially cylinder-shaped and downwardly tapered spring 33 integrally formed therewith and made of leaf springs 33a, so that the spring 33 makes a stable contact with the inserted lead 63 or 64 to hold it releasably and securely.

As shown in Fig. 3, the smaller diameter portion 35 of the connecting terminal 31, when it is fitted in the associated through-hole 19, is extended out straight downwardly beyond the contact surface 21 of the support 12. Then, the portions 35 are angled in response to the circuit pattern of the circuit substrate 51 as shown in Figs. 2 and 4 and accommodated within the grooves 15 to extend outwardly for soldering, which allows the surface-mounting of the socket (see Fig. 8).

The socket 11 so constructed is securely soldered on a predetermined position of the circuit substrate 51 by the reflow process to hold the electrolytic capacitors 61.

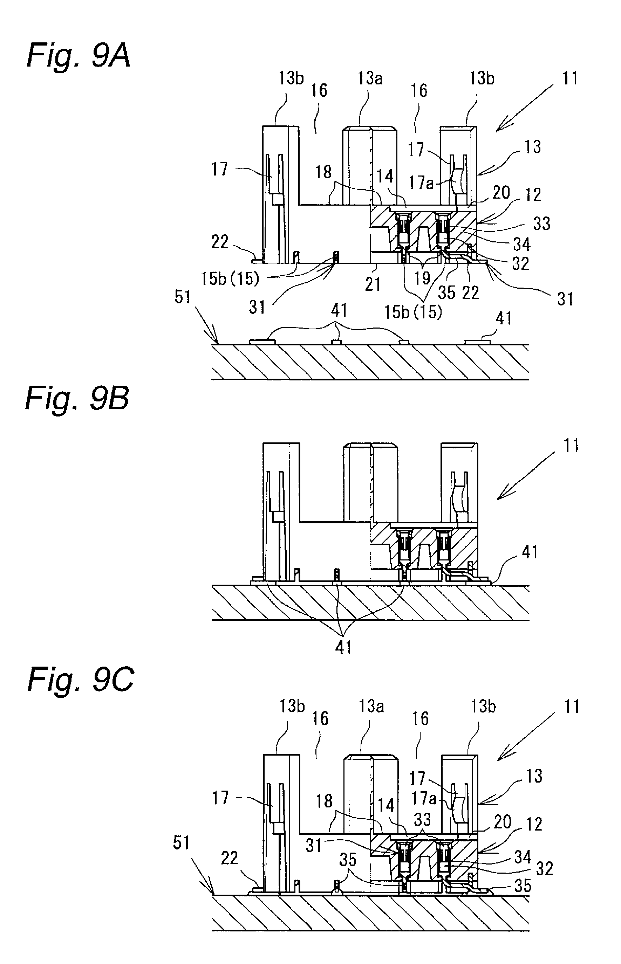

Specifically, as shown in Fig. 9A, the solder paste is applied to the predetermined portions of the circuit substrate where the fixing clamps 22 and the connecting terminals 31 will be positioned. Next, as shown in Fig. 9B, the socket 11 is positioned on the solder pastes 41 applied to the substrate. Finally, the solder paste 41 is heated and melt in the reflow oven to execute the soldering (see Fig. 9C). The soldering processes are likewise performed to other electric components 42 as shown in Fig. 1.

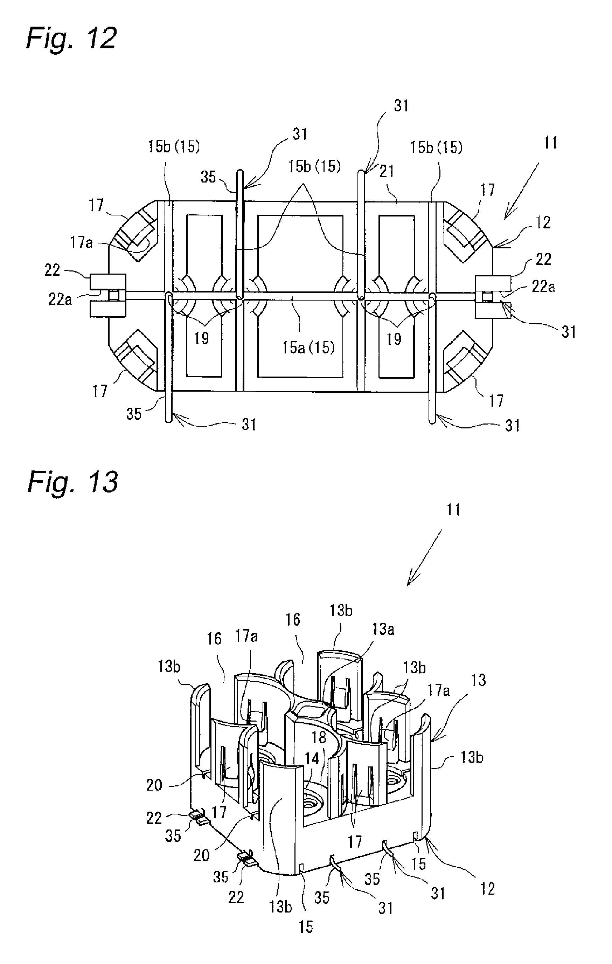

The small diameter portions 35 of the connecting terminals 31 extending from the bottom surface of the socket 11 are angled in the required directions and then drawn out of the socket 11. For example, as shown in Fig. 12, the positive and negative terminals can be drawn out in the same direction, which expands the possibility of circuit design to simplify a circuit structure of the circuit substrate 51, for example. This in turn results in a high-density circuit design and a reduction of manufacturing cost.

Further, the socket 11 is fixedly mounted on the circuit substrate 51 by soldering, which ensures a surface contact between the contact surface 21 of support 12 and the surface of the circuit substrate 12 and, as a result, a stable and vibration-resistance mounting in combination with the solder fixing.

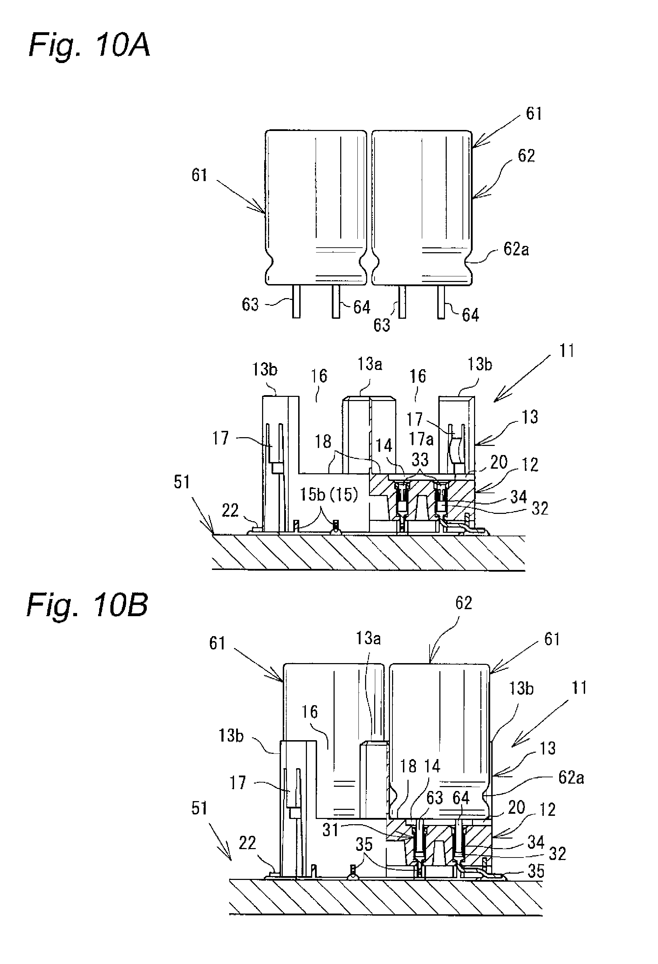

Subsequently, as shown in Fig. 10A, the leads 63 and 64 of the electrolytic capacitor 61 are coaxially aligned with the associated through-holes 19 of the socket 11 (i.e., insert holes 32 of the connecting terminals 31). Then, the housing 62 is inserted within the holder 13. In this operation, the positive and negative leads 63 and 64 are connected to the associated positive and negative connecting terminals 31, respectively. A modification in which the connecting terminals 31 have different lengths (e.g., the positive terminal is longer than the negative terminal) or any mark is provided at the bottom of the recess 14 ensures a correct connection of the capacitor and the socket without mixing up positive and negative polarities. An automatic mounting of the capacitors 61 ensures the positive and negative leads to be pre-oriented precisely, so that there is no need to provide such marks.

Further, the support 12 has the connecting groove 20 as described above and the groove 20 may work as an appropriate guide for insertion of the capacitor (see Fig. 7).

Furthermore, the insertions of the leads 63 and 64 can be performed without receiving excessive resistance because the peripheral walls of the insertion holes 32 are made of springs 33.

As shown in Fig. 10B, when the electrolytic capacitor 61 is received by the socket 11, the leads 63 and 64 are fully accommodated within the holes 32 of the contact terminals 31 to form stable electric contacts and connections with the contact terminal 31 by the biasing forces from the springs 31 provided in the insert holes 32. Also, the housing 62 of the capacitor 61 is firmly held by the engaging springs 17.

In this condition, the lowermost end surface of the housing 62 is in contact with the receiving surface portion 18 of the support 12 and thereby retained in a stable manner. This ensures an elevated resistance to vibrations, so that no considerable stress will act on the leads 63, 64 even in the vibration environment.

Also, during the insertion of the housing 62 of the capacitor 61 into the holder 13, the engaging springs 17 of the holder 13 are elastically forced outwardly and then the distal projections 17a are clickingly engaged with the constrictions 62a, which provides a comfortable click feeling at the completion of the mounting of the capacitor. This also ensures a stable mounting of the capacitor without causing any excessive stress to the housing 62.

Further, since the engaging springs 17 of the holder 13 are extended downwardly, they can be designed to have a length longer than that when being extended upwardly, which ensures sufficient elastic deformations of the springs. Therefore, the commercially available and widely used electrolytic capacitors 61 can be retained firmly even when they have differences in diameter of the housings 62 and/or in size and shape of the constrictions 62a.

Furthermore, when the internal pressure of the electrolytic capacitor 61 is increased due to heat generated during operations thereof and thereby the seal rubber 65 is deformed by thermal expansion thereof, as shown in Fig. 8 the deformation is accommodated by the recess 14 of the support to prevent the housing 62 from being raised which would otherwise be caused by the deformation and to ensure a stable holding of the capacitor by the holder 13. Also, a liquid leaked from the capacitor, if any, is received by the recess 13 to prevent the leaked liquid from flowing into contacts with another components or portions. This is also prevented by the fact that the holes 32 of the connecting terminal 31 are designed as bottomed holes.

Moreover, the connecting groove 20 allows air to flow between the recess and the atmosphere, which prevents a pressure increase and decrease in the recess due to the deformations of the seal rubber 65 and an upward movement of the housing 62 which would otherwise be caused thereby. Therefore, the retaining force of the capacitor is maintained reliably.

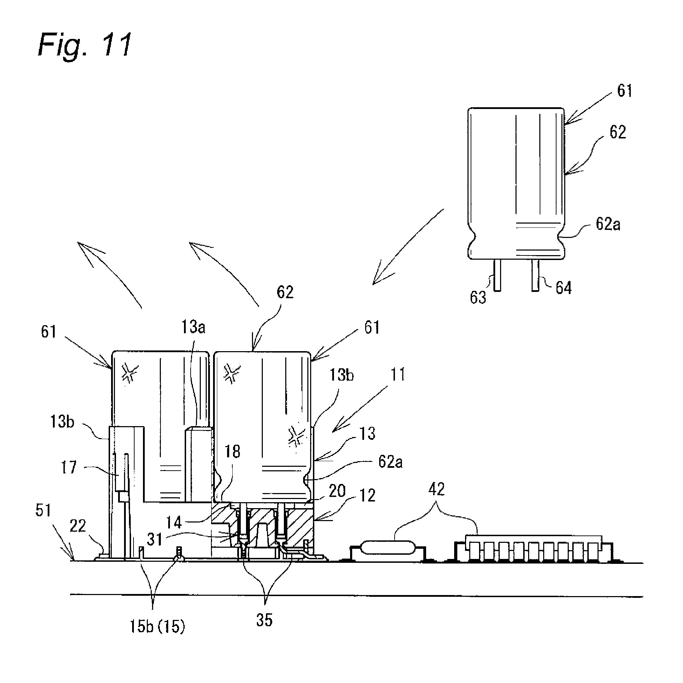

As shown in Fig. 11, the deteriorated capacitors 61 can be dismounted from the socket 11 and replaced by new ones. The circuit on the circuit substrate can be used with the new capacitors, so that the circuit substrate 51 does not need to be discarded with the deteriorated capacitor.

As described above, the capacitor 61 can be retained in a stable manner irrelevant to the deformations caused in the capacitor. Also, the capacitor 61 can work without being affected by vibrations. Further, the liquid leaked from the capacitor is prohibited from flowing into contact with other components. Therefore, the circuit is well reused for the newly replaced capacitors.

Also, the electrolytic capacitor 61 is mounted on the socket 11 which has already been mounted on the circuit substrate 51 together with other electric components 42. This prevents the electrolytic capacitor 61 from being exposed to high temperature at its mounting to maintain its performance.

Further, the no electrolytic capacitor exists at the reflow soldering. This allows that not only low capacitance capacitor but also high capacitance can be surface-mounted. As a result, although the conventional circuit, in particular, including high capacitance capacitor has both lead component and surface-mounting component and therefore needs two soldering processes, i.e., both reflow and flow solderings, the soldering process can be completed by the reflow soldering only. While meeting with the requirements of multifunctionality, compactness and high-density mounting of electronic devices, the manufacturing of the circuit can be made more simple and economical. Although Fig. 1 shows an embodiment in which the electric components are mounted on one side of the substrate, the present invention can be applied equally to the dual surface mounting in which the electric components are mounted on both sides of the substrate.

Also, the surface-mounting ensures that a fine soldering can be made easily and economically.

Other modifications will be described below. In the following descriptions, like parts are designated by like reference numerals and therefore no descriptions will be duplicated for those parts.

Fig. 13 shows a socket 11 on which four electrolytic capacitors can be mounted. As shown in the drawing, the support 12 and the holder 13 are suitably configured to receive a required number of electrolytic capacitors.

In the above-described arrangements and structures according to the several embodiments, the drawing passage corresponds to the drawing groove 15 and the engaging means corresponds to the engaging spring 17 but the invention is not limited thereto and other modifications can be contemplated and employed. For example, the drawing passages may be a cavity capable of retaining the small diameter portion of the connecting terminal and may take another configuration, rather than groove.

Also, the size and the number of the electrolytic capacitors to be mounted on the socket may be determined as necessary.

Further, instead of the connecting terminals described above, another structure having a leaf spring, for example, and capable of retaining the leads may be used.

## Claims

1. A socket for a surface-mounting of an electrolytic capacitor, the capacitor having a housing and leads extending from a bottom surface of the housing, comprising:
a support for receiving the bottom surface of the capacitor, the support having
a holder for releasably holding a portion of the housing of the capacitor adjacent to the leads,
connecting terminals for electrically connecting the leads to a circuit substrate,
a recess defined in a top surface of the support for accommodating a deformation of a seal rubber provided at a bottom portion of the housing of the capacitor, and
drawing passages defined in a bottom surface of the support for drawing the connecting terminals.

2. The socket of claim 1, wherein the support has a groove extending from an outer peripheral surface of the support to the recess.

3. The socket of claim 2, wherein the groove is positioned on a plane crossing the connecting terminals to which the leads are connected.

4. The socket in any one of claims 1-3, wherein the support has an engaging means for an engagement with a constriction defined in the housing of the electrolytic capacitor.

5. The socket of claim 4, wherein the engaging means is made of an engaging spring which is extended downwardly from an upper portion of the holder and is elastically deformable in an inside-outside direction.

6. The socket in any one of claims 1-5, wherein the drawing passages are made of grooves designed to accommodate the respective connecting terminals.

7. The socket in any one of claims 1-6, wherein each of the connecting terminals has a bottomed-hole into which the lead is inserted and a spring provided at an inner surface of the bottomed-hole for elastically holding the inserted lead.

8. A method for a surface-mounting of an electrolytic capacitor, comprising the steps of
mounting the socket in any one of claims 1-7 on a circuit substrate by a reflow process; and
retaining the electrolytic capacitor by the holder.
